Europäisches Patentamt

(19) European Patent Office

Office européen des brevets

(11) Veröffentlichungsnummer: **0 054 338**
**B1**

(12) **EUROPÄISCHE PATENTSCHRIFT**

(45) Veröffentlichungstag der Patentschrift:
30.05.84

(51) Int. Cl.³: **H 03 K 19/017,** H 03 K 19/096

(21) Anmeldenummer: **81201370.4**

(22) Anmeldetag: **14.12.81**

(54) **Verknüpfungsschaltung in 2-Phasen-MOS-Technik.**

(30) Priorität: **15.12.80 DE 3047222**

(43) Veröffentlichungstag der Anmeldung:
**23.06.82 Patentblatt 82/25**

(45) Bekanntmachung des Hinweises auf die Patenterteilung:
**30.05.84 Patentblatt 84/22**

(84) Benannte Vertragsstaaten:
**DE FR GB**

(56) Entgegenhaltungen:
**DE - A - 2 801 285**
**DE - B - 1 787 011**
**DE - B - 1 953 975**
**GB - A - 2 069 271**
**US - A - 4 048 518**

(73) Patentinhaber: **Philips Patentverwaltung GmbH,
Billstrasse 80, D-2000 Hamburg 28 (DE)**
(84) Benannte Vertragsstaaten: **DE**

(73) Patentinhaber: **N.V. Philips' Gloeilampenfabrieken,
Groenewoudseweg 1, NL-5621 BA Eindhoven (NL)**
(84) Benannte Vertragsstaaten: **FR GB**

(72) Erfinder: **Mathes, Egon, Gerlingweg 105,
D-2200 Elmshorn (DE)**

(74) Vertreter: **Poddig, Dieter et al, Philips Patentverwaltung
GmbH Billstrasse 80 Postfach 10 51 49,
D-2000 Hamburg 28 (DE)**

## Beschreibung

Die Erfindung betrifft eine Verknüpfungsschaltung in 2-Phasen-MOS-Technik mit mehreren gleichen Verknüpfungsgliedern, die je aus einer Reihenschaltung von die zu verknüpfenden Eingangssignale empfangenden MOS-Transistoren sowie eines ein Abfrage-Taktsignal empfangenden Abfrage-MOS-Transistors bestehen, wobei das eine Ende jeder Reihenschaltung mit einem Bezugspotential und das andere Ende jeder Reihenschaltung über einen gemeinsamen Auflade-MOS-Transistor, der das Auflade-Taktsignal empfängt mit einer Betriebsspannung verbunden ist, wobei die Abfrage-Transistoren und der Auflade-Transistor niemals gleichzeitig leitend sind und die von der Betriebsspannung abgewandte und mit den Reihenschaltungen verbundene Hauptelektrode des Auflade-MOS-Transistors den Ausgang der Verknüpfungsschaltung darstellt, an den das Gate mindestens eines Ausgangs-MOS-Transistors angeschlossen ist, der bei einer Spannung am Ausgang der Verknüpfungsschaltung zwischen der Betriebsspannung und einem Bruchteil davon ein eindeutig niedriges Signal abgibt.

Derartige Verknüpfungsschaltungen sind bekannt, beispielsweise aus DE-AS 17 87 011. Zur Ansteuerung derartiger Verknüpfungsschaltungen wird abwechselnd ein Auflade-Taktimpuls ø2 und jeweils danach ein Abfrage-Taktimpuls ø1 zugeführt. Während des Auflade-Taktsignals ø2 lädt der dann leitende Auflade-Transistor den Ausgang der Verknüpfungsschaltung mindestens bis nahe der Betriebsspannung auf. Gleichzeitig erhalten die Eingänge der Transistoren in den einzelnen Reihenschaltungen die zu verknüpfenden Eingangssignale. Bei dem anschliessenden Abfrage-Taktsignal ø1 ist der Auflade-Transistor gesperrt und dafür die Abfrage-Transistoren leitend, die jede Reihenschaltung mit dem Bezugspotential verbinden. Wenn nun eine Reihenschaltung vorhanden ist, in der alle Transistoren ohne Ausnahme leitend sind (erfüllte UND-Bedingung), wird über diese Reihenschaltung der Ausgang der Verknüpfungsschaltung auf das Bezugspotential entladen.

Wenn nun eine grosse Anzahl von Reihenschaltungen miteinander verbunden ist, werden alle oberen Punkte der Reihenschaltungen mit entladen. Wenn dann ausserdem die Reihenschaltungen eine grosse Anzahl von MOS-Transistoren enthalten, um viele Eingangssignale zu verknüpfen, und in vielen Reihenschaltungen sind viele aufeinanderfolgende, mit diesem oberen Punkt der Reihenschaltung verbundene Transistoren leitend geschaltet und erst der bzw. die dem Bezugspotential zugewandten Transistoren sind gesperrt, stellt jede Reihenschaltung eine erhebliche kapazitive Belastung dar, so dass die Entladung über die eine vollständig leitende Reihenschaltung relativ lange Zeit benötigt. Dadurch wird die Schaltgeschwindigkeit der gesamten Verknüpfungsschaltung herabgesetzt.

Aufgabe der Erfindung ist es, eine Verknüpfungsschaltung der eingangs genannten Art anzugeben, bei der auch bei ungünstigster Kombination der zu verknüpfenden Eingangssignale eine möglichst hohe Schaltgeschwindigkeit und damit eine möglichst hohe Folgefrequenz der Taktsignale ermöglicht wird.

Diese Aufgabe wird erfindungsgemäss dadurch gelöst, dass in der Verbindung jeder Reihenschaltung mit dem Auflade-MOS-Transistor ein zusätzlicher MOS-Transistor angeordnet ist und alle zusätzlichen MOS-Transistoren gemeinsam ein derartiges Signal am Gate erhalten, das zumindest während der leitenden Phase der Abfrage-MOS-Transistoren zumindest bei Spannungen am Ausgang der Verknüpfungsschaltung zwischen der Betriebsspannung und einem unterhalb des Bruchteils davon liegenden Wert jeder zusätzliche MOS-Transistor zwischen dem Auflade-MOS-Transistor und einer Reihenschaltung mit mindestens einem gesperrten Transistor gesperrt ist. Die zusätzlichen MOS-Transistoren wirken somit ähnlich wie Dioden, die einen Stromfluss nur bei leitendem Auflade-MOS-Transistor zum Aufladen der Reihenschaltung ermöglichen, die jedoch gesperrt sind, bis eine leitende Reihenschaltung den Ausgang soweit entladen hat, dass der Ausgangs-MOS-Transistor gesperrt ist. Eine leitende Reihenschaltung braucht zumindest während dieser Entladezeit nur die Kapazität am Ausgang der Verknüpfungsschaltung zu entladen, nicht jedoch die übrigen aufgeladenen Reihenschaltungen.

Die zusätzlichen MOS-Transistoren sind zweckmässig Anreicherungs-MOS-Transistoren, weil diese für diesen Zweck am einfachsten ansteuerbar sind. So kann nach einer Ausführung das Signal an den Gates der zusätzlichen MOS-Transistoren eine Gleichspannung sein mit einem Wert kleiner als die Summe der niedrigsten Spannung, bei der der an dem Ausgang der Verknüpfungsschaltung angeschlossene Ausgangs-MOS-Transistor noch ein eindeutig niedriges Signal abgibt, und der Schwellenspannung der zusätzlichen MOS-Transistoren. Dadurch werden die zusätzlichen MOS-Transistoren der nichtleitenden Reihenschaltungen erst dann leitend, wenn die Spannung am Ausgang der Verknüpfungsschaltung so weit abgesunken ist, dass der Ausgangs-MOS-Transistor das endgültige eindeutige Ausgangssignal abgibt, so dass die infolge der leitend gewordenen zusätzlichen MOS-Transistoren langsamer erfolgende Entladung sich nicht mehr auf das Ausgangssignal des Ausgangs-MOS-Transistors auswirkt.

Eine andere Ausführungsform besteht darin, dass das Signal an den Gates der zusätzlichen MOS-Transistoren die Spannung am Ausgang der Verknüpfungsschaltung ist. In diesem Falle wirken die zusätzlichen MOS-Transistoren der nichtleitenden Reihenschaltungen tatsächlich über den gesamten Spannungsbereich wie Dioden, jedoch wird nun der Ausgang der Verknüpfungsschaltung durch die Kapazität der Gates der zusätzlichen MOS-Transistoren belastet.

Eine dritte Möglichkeit besteht darin, dass das Signal an den Gates der zusätzlichen MOS-Transistoren ein Taktsignal ist, dessen Spannungswert bei leitenden Abfrage-MOS-Transistoren kleiner ist als die Summe der niedrigsten Spannung, bei der der an den Ausgang der Verknüpfungsschaltung angeschlossene Ausgangs-MOS-Transistor (T5) noch ein eindeutig niedriges Signal abgibt, und der Schwellenspannung der zusätzlichen MOS-Transistoren, und dessen Spannungswert mindestens bei leitendem Auflade-MOS-Transistor grösser ist. Dabei werden während der Aufladephase die Reihenschaltungen auf einen höheren Spannungswert aufgeladen, so dass bei der anschliessenden Abfragephase, wenn keine der Reihenschaltungen leitend wird, der hohe Pegel am Ausgang der Verknüpfungsschaltung zuverlässiger gewährleistet ist. Daher ist es für diese dritte Möglichkeit zweckmässig, dass der Spannungswert des Taktsignals bei leitendem Auflade-MOS-Transistor gleich der Betriebsspannung ist. Ein solcher Spannungswert ist leicht zu erzeugen und bewirkt eine ausreichend hohe Aufladung aller Reihenschaltungen bzw. mindestens von deren oberen, mit den zusätzlichen MOS-Transistoren verbundenen Punkten.

Ausführungsbeispiele der Erfindung werden nachstehend anhand der Zeichnung näher erläutert: Es zeigen:

Fig. 1 ein Schaltbild einer erfindungsgemässen Verknüpfungsschaltung mit nachgeschaltetem Flipflop,

Fig. 2 einige Diagramme mit dem zeitlichen Verlauf einiger Signalspannungen.

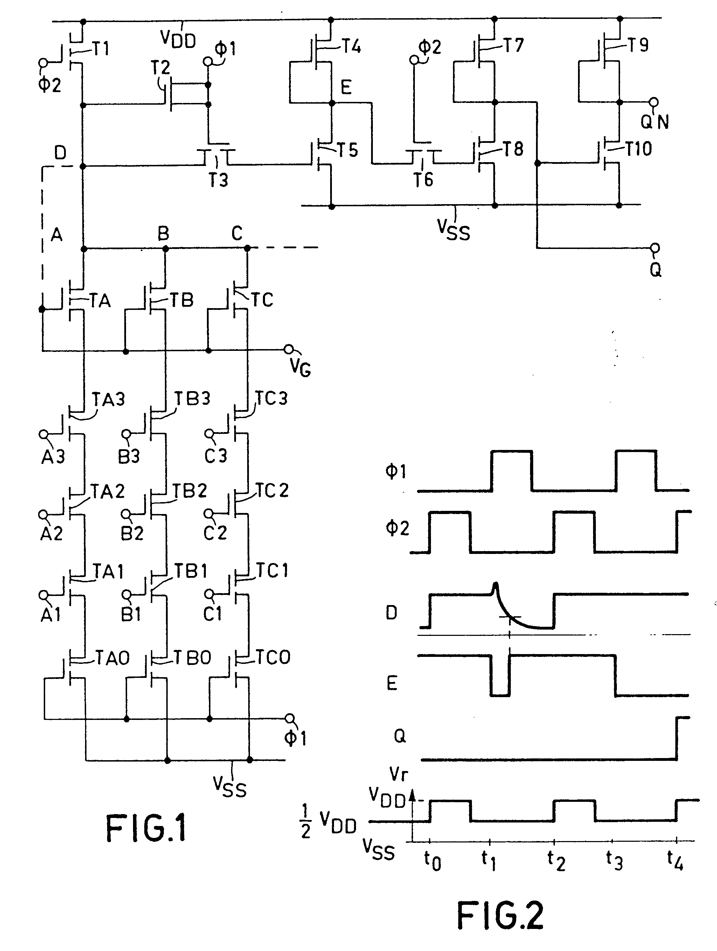

Die in Fig. 1 dargestellte Schaltung enthält ausschliesslich MOS-Transistoren, die daher in der weiteren Beschreibung nur als Transistoren bezeichnet werden. In der Schaltung sind drei Stränge A, B und C dargestellt, die je aus einer Reihenschaltung von mehreren Transistoren bestehen. Es sind hier nur drei Stränge als Beispiel dargestellt, während in der Praxis eine wesentlich grössere Anzahl von Strängen mit einer ebenfalls grösseren Anzahl von Transistoren verwendet wird, um eine entsprechend grössere Anzahl von Verknüpfungsfunktionen zu realisieren.

Die oberen Enden der Stränge A, B und C sind miteinander und mit einem Schaltungspunkt D verbunden, der den Ausgang der Verknüpfungsschaltung darstellt und der über einen durch das Taktsignal ø2 gesteuerten Aufladetransistor T1 mit der Betriebsspannung $V_{DD}$ verbunden ist. An den Ausgang D ist über einen vom Taktsignal ø1 gesteuerten Übertragungs-Transistor T3 das Gate eines Ausgangs-Transistors T5 angeschlossen. Die Drain des Ausgangs-Transistors T5 ist über einen als Lastwiderstand geschalteten Transistor T4 mit der Betriebsspannung $V_{DD}$ sowie über einen weiteren, vom Taktsignal ø2 gesteuerten Übertragungs-Transistor T6 mit dem Gate eines zweiten Ausgangs-Transistors T8 verbunden, dessen Drain wieder über einen als Lastwiderstand geschalteten Transistor T7 an der Betriebsspannung $V_{DD}$ und an dem Ausgang Q sowie an dem Gate eines dritten Ausgangs-Transistors T10 liegt, dessen Drain über den als Lastwiderstand arbeitenden Transistor T9 mit der Betriebsspannung $V_{DD}$ sowie mit dem weiteren Ausgang QN verbunden ist.

Die Transistoren T4, T7 und T9 sind Verarmungs-Feldeffekt-Transistoren, die leitend sind und in diesem Falle als Stromquellen wirken, wenn deren Gate mit einer der Hauptelektroden verbunden ist, wie daraus hervorgeht, dass der die Hauptstrombahn andeutende, dem Gate gegenüberliegende Strich durchgezogen ist, während u.a. die Transistoren T5, T6, T8 und T10 Anreicherungs-Feldeffekt-Transistoren sind, bei denen dieser die Hauptstrombahn andeutende Strich unterbrochen dargestellt ist, da derartige Transistoren erst dann leitend sind, wenn das Potential am Gate um eine Schwellwertspannung $V_{TH}$ positiver ist als das Potential an einer der Hauptelektroden. Bei beiden Arten von Transistoren sind jedoch die Hauptelektroden vertauschbar, d.h. ein Strom kann in beiden Richtungen durch den Transistor fliessen, was für die spätere Erläuterung von Bedeutung ist.

In der dargestellten Schaltung stellen die Transistorpaare T4 und T5, T7 und T8 sowie T9 und T10 jeweils einen Inverter dar, der das Bezugspotential entsprechend dem negativen Pol $V_{SS}$ der Betriebsspannung, mit der der Anreicherungstransistor jedes Inverters verbunden ist, am Ausgang abgibt, wenn die Spannung am Gate des Anreicherungstransistors höher ist als die Schaltspannung $V_T$ des Anreicherungstransistors, und der bei niedrigerer Spannung am Gate die positive Betriebsspannung $V_{DD}$ am Ausgang abgibt. Diese Schaltspannung ist höher als die Schwellwertspannung $V_{TH}$ des mit der Bezugsspannung $V_{SS}$ verbundenen Anreicherungs-Transistors, denn dieser muss noch weiter in den leitenden Zustand gesteuert werden, bis er den Strom des mit der positiven Betriebsspannung verbundenen Verarmungs-Transistors vollständig übernehmen kann. Dadurch kann die Schaltspannung jedes Inverters durch entsprechende geometrische Dimensionierung seiner beiden Transistoren in einem gewissen Rahmen eingestellt werden. Die letzten beiden Inverter mit den Transistoren T6 bis T10 stellen dabei ein D-Flipflop dar, das das Signal am Schaltungspunkt E mit dem Takt ø2 übernimmt und an den zueinander komplementären Ausgängen Q bzw. QN abgibt und dieses Signal auch nach dem Ende des Taktes Q2 noch aufrechterhält, da bei gesperrtem Übertragungstransistor T6 das Signal am Gate des Transistors T8 durch die Gatekapazität gespeichert bleibt. Diese Weiterverarbeitung des Ausgangssignals des Ausgangs-Transistors T5 durch ein D-Flipflop stellt nur eine Möglichkeit dar und ist hier nur beispielsweise erwähnt.

Die Reihenschaltung A enthält mehrere Anreicherungs-Feldeffekt-Transistoren. Von dem untersten Transistor TA0, der den Abfragetransistor darstellt, ist die eine Hauptelektrode mit dem Bezugspotential $V_{SS}$ verbunden, und das Gate dieses Transistors erhält das Taktsignal ø1. Es sei bemerkt, dass dieser Abfragetransistor TA0 auch an einer anderen Stelle in der Reihenschaltung angeordnet sein kann. Bei der hier dargestellten Anordnung ist an die andere Hauptelektrode die Reihenschaltung von drei weiteren Transistoren TA1 bis TA3 angeschlossen, deren Gates über die Eingangsanschlüsse A1 bis A3 die zu verknüpfenden Signale erhalten. Die Reihenschaltung endet mit dem Transistor TA, der am Gate das Signal $V_G$ erhält und der gemeinsam mit den entsprechenden Transistoren der anderen Reihenschaltungen mit dem Schaltungspunkt D verbunden ist. Wenn an allen Eingängen A1 bis A3 sowie am Anschluss $V_G$ positive Signalwerte anliegen, sind während der Taktphase ø1, während der das entsprechende Taktsignal ø1 positiv ist, alle Transistoren der Reihenschaltung leitend, so dass dann eine leitende Verbindung zwischen dem Schaltungspunkt D und dem Bezugspotential $V_{SS}$ vorhanden ist und diese den Schaltungspunkt D auf dieses Potential herabzieht. Die Reihenschaltung A realisiert somit eine NAND-Verknüpfung der Signale an den Eingängen A1 bis A3, bezogen auf den Ausgang D der Verknüpfungsschaltung.

In Reihenschaltung B sind die Transistoren TB2 und TB3 Verarmungs-Feldeffekt-Transistoren, die stets, d.h. auch bei einem niedrigen Signal am Eingang B2 bzw. B3 leitend sind. Die Reihenschaltung B ist somit bereits vollständig leitend, wenn bei entsprechenden hohen Signalen an den Eingängen VG und ø1 nur der Eingang B1 ein hohes Signal erhält. Der Grund für diese Massnahme ist, dass in der Praxis eine wesentlich grössere Anzahl von einzelnen Reihenschaltungen mit jeweils einer wesentlich grösseren Anzahl von Transistoren vorhanden sind, die verschiedene Kombinationen der gleichen Eingangssignale entschlüsseln sollen, so dass die ganze Anordnung als Matrix aus den Reihenschaltungen von Transistoren und diese kreuzenden Eingangsleitungen aufgebaut ist. Die Eingangsleitung, die in einer speziellen Reihenschaltung auch mit einem niedrigen Signal die UND-Bedingung erfüllen soll, führt dann auf einen Verarmungs-Transistor. Bei der Reihenschaltung C ist dies beispielsweise nur bei dem Transistor TC2 der Fall. Jede Reihenschaltung stellt also eine NAND-Verknüpfung einer anderen Kombination von Eingangssignalen dar, die über die gemeinsame Verbindung mit dem Schaltungspunkt D ODER-mässig zusammengefasst sind.

Die Funktion dieser Schaltung, d.h. der zeitliche Verlauf einzelner Signale, soll nun anhand der Fig. 2 erläutert werden. Darin ist der zeitliche Verlauf der Taktsignale ø1 und ø2 dargestellt, die also abwechselnd positiv werden, wobei keine Überlappung auftreten darf, sondern eine kleine Lücke zwischen den abwechselnden Taktsignalen auftreten muss, in der beide Taktsignale niedrig sind.

Zum Zeitpunkt $t_0$ wird das Auflade-Taktsignal ø2 positiv, wodurch auch der Schaltungspunkt D positiv wird, da das Taktsignal ø1 gleichzeitig niedrig ist und alle Reihenschaltungen über die Transistoren TA0, TB0, TC0 usw. sperrt. Der Schaltungspunkt D erreicht dabei eine Spannung, die um die Schwellwertspannung $V_{TH}$ des Transistors T1 niedriger ist als der hohe Wert des Taktsignals ø2, der gleich der positiven Betriebsspannung $V_{DD}$ angenommen wird. Diese Spannung bleibt auch nach dem Ende des Taktsignals ø2 zunächst erhalten, da der Schaltungspunkt D eine Kapazität gegenüber anderen Schaltungsteilen mit konstanter Spannung aufweist, die die Aufladung für eine gewisse Zeit aufrechterhält.

Mit dem Zeitpunkt $t_1$ nimmt das Taktsignal ø1 einen hohen Wert an, so dass der Transistor T3 leitend wird und einen Teil der Ladung des Schaltungspunktes D auf die Kapazität des Gates des Transistors T5 überträgt. Um dabei eine zu grosse Spannungsabnahme des Schaltungspunktes D zu vermeiden, ist der als Kapazität geschaltete Transistor T2 vorgesehen, der eine entsprechende oder etwas grössere Ladung vom Taktsignal ø1 auf den Schaltungspunkt D überträgt. Da das Gate des Transistors T5 somit positiv wird, nimmt der Schaltungspunkt E die Spannung $V_{SS}$ an. Zu diesem Zeitpunkt ist allerdings der Transistor T6 gesperrt, da das Taktsignal ø2 niedrig ist.

Mit Beginn des Taktsignals ø1 zum Zeitpunkt $t_1$ werden ausserdem die Transistoren TA0, TB0 und TC0 leitend. Für die weitere Erläuterung werden die Transistoren TA, TB und TC zunächst unberücksichtigt gelassen bzw. durch eine ständig leitende Verbindung ersetzt. Während der vorhergehenden Taktphase ø2 waren die Signale an den Eingängen A1 bis A3, B1 bis B3 und C1 bis C3 angelegt worden, und es werden derartige Signale angenommen, die die Transistoren TA1 bis TA3 sowie TC3 in den leitenden Zustand bringen und die Transistoren TB1 und TC1 sperren. Die Transistoren TB2, TB3 und TC2 sind ohnehin leitend, da es Verarmungs-Transistoren sind. Damit ist die Reihenschaltung A bis einschliesslich der Verbindung der Transistoren TA0 und TA1 auf das Potential des Schaltungspunkts D aufgeladen, entsprechend die Reihenschaltung B bis zur Verbindung zwischen den Transistoren TB1 und TB2 und die Reihenschaltung C bis zur Verbindung der Transistoren TC1 und TC2. Wenn nun mit Beginn des Taktsignals ø1 die Transistoren TA0 bis TC0 leitend werden, bildet nur die Reihenschaltung A eine leitende Verbindung zwischen dem Schaltungspunkt D und dem Bezugspotential $V_{SS}$, so dass darüber der Schaltungspunkt D entladen wird. Wenn aber die Transistoren TA bis TC durch eine leitende Verbindung ersetzt gedacht sind, müssen auch die Reihenschaltungen B und C bis zu den gesperrten Transistoren TB1 und TC1 entladen werden. Diese Reihenschaltungen bzw. die darin leitend geschalteten Transistoren bilden eine erhebliche Kapazität. Da die Reihenschaltungen nicht beliebig niederohmig ausgeführt werden können, sinkt die Spannung am Schaltungspunkt D und damit die Spannung am Gate des Transistors T5 nur relativ langsam. Das Taktsignal ø1 muss nun so lange hoch sein, bis der Schaltungspunkt D sich bis unter die Schaltspannung des Inverters T4 entladen hat, damit der Schaltungspunkt E als endgültiges Signal wieder ein eindeutiges hohes Potential annehmen kann, das mit dem folgenden Taktsignal ø2 über den Transistor T6 auf den Transistor T8, d.h. auf das D-Flipflop, übertragen wird. Da erst nach dem Ende des Taktsignals ø1 das Taktsignal ø2 wieder positiv werden darf, wird damit die maximale Folge verschiedener Eingangssignale, die verknüpft werden sollen, d.h. die maximale Schaltfrequenz stark begrenzt. Entsprechend dieser Verzögerung bei der Entladung tritt auch eine Verzögerung bzw. Verlängerung der Aufladung in der folgenden Taktphase ø2 auf, wenn alle Reihenschaltungen entladen waren und nun gleichzeitig parallel über den Auflade-Transistor T1 wieder aufgeladen werden müssen.

Diese Verzögerung der Umladung wird durch die Transistoren TA, TB und TC vermieden. Diese erhalten gemeinsam an ihren Gates ein Signal $V_G$, für das verschiedene Möglichkeiten bestehen. Dies soll anhand von Zahlenbeispielen deutlich gemacht werden, für die folgende Annahmen gemacht werden:

Betriebsspannung $V_{DD} = 5V$
$V_{SS} = 0V$
Schwellenspannung der Transistoren T1, TA, TB und TC

$$V_{TH} = 1V$$

Im ersten Fall wird angenommen, dass das Signal $V_G$ eine Gleichspannung mit dem Wert 2,5V ist. Wenn das Taktsignal ø2 auf 5V geht, lädt sich der Schaltungspunkt D auf eine Spannung $5V - V_{TH} = 4V$ auf. Die einzelnen Reihenschaltungen A,B und C laden sich jedoch nur bis auf eine Spannung $V_G - V_{TH} = 1,5V$ auf, da dann die Transistoren TA, TB und TC in den nichtleitenden Zustand übergehen. Wenn nun wie im vorher beschriebenen Beispiel angenommen wird, dass die Transistoren TA1 bis TA3 der Reihenschaltung A durch entsprechende Eingangssignale leitend sind, wird mit Beginn des Taktsignals ø1 die Reihenschaltung A über den Transistor TA0 mit der Bezugsspannung $V_{SS}$ verbunden, so dass der Transistor TA nunmehr leitend wird und der Schaltungspunkt D entladen wird. Die Transistoren TB und TC bleiben dagegen noch an der Grenze des leitenden Zustands, so dass kein Strom aus den Kapazitäten, die die Transistoren der Reihenschaltungen B und C darstellen, zum Schaltungspunkt D und damit über die Reihenschaltung A nach $V_{SS}$ fliessen kann.

Damit erfolgt die Entladung des Schaltungspunktes D relativ rasch, bis eine Spannung von 1,5V erreicht ist. Erst in diesem Augenblick werden die Transistoren TB und TC leitend, da dann die oberen Hauptelektroden dieser Transistoren um die Schwellwertspannung $V_{TH} = 1V$ negativer sind als die Spannung VG = 2,5V an den Gates dieser Transistoren. Erst dann fliesst ein Strom aus den Kapazitäten, die die Transistoren der Reihenschaltungen B und C darstellen, in die Reihenschaltung A hinein und verlangsamt die Entladung des Schaltungspunktes D. Wenn der Inverter T4/T5 so dimensioniert ist, dass er bei einer Eingangsspannung von 1,5 V schon am Schaltungspunkt E wieder hohes Potential erzeugt, wirkt sich die Verzögerung der Entladung, die bei der Spannung von 1,5V am Schaltungspunkt D einsetzt, nicht mehr auf das endgültige Signal am Schaltungspunkt E aus, so dass das Taktsignal ø1 bereits vor der vollständigen Entladung des Schaltungspunktes D wieder auf 0V zurückkehren kann, da dann am Gate des Transistors T5 eine Spannung gespeichert bleibt, die am Punkt E noch hohes Potential zur Folge hat. Dies ist in Fig. 2 bei der Kurve D dargestellt, bei der die Schaltspannung des Inverters T4/T5 als waagerechter Strich durch die Entladungskurve dargestellt ist, wobei nach diesem Schnittpunkt die Kurve E wieder hoch ist. Mit dem nächsten Taktsignal ø2 beim Zeitpunkt $t_2$ wird diese hohe Spannung des Schaltungspunktes E über den Übertragungstransistor T6 auf das Flipflop übertragen, das allerdings diesen Zustand bereits innehatte, wie die mit Q bezeichnete Kurve des Ausgangssignals des Flipflops am Ausgang Q zeigt.

Während des Taktsignals ø2, das mit dem Zeitpunkt $t_2$ beginnt, werden den Eingängen A1 bis A3 usw. der Reihenschaltungen A, B und C andere Signale zugeführt, die nun eine derartige Kombination haben mögen, dass keine der Reihenschaltungen mit dem zum Zeitpunkt $t_3$ beginnenden folgenden Taktsignals ø1 leitend ist und der Schaltungspunkt D somit nicht entladen wird. Damit geht der Schaltungspunkt E zum Zeitpunkt $t_3$ auf das Bezugspotential $V_{SS}$, und mit dem nächsten Taktsignal ø2 zum Zeitpunkt $t_4$ wird dieses Potential über den Übertragungstransistor T6 auf das Flipflop übertragen, so dass nun der Ausgang Q ein hohes Potential annimmt.

Durch die Verwendung der Transistoren TA, TB und TC und Anlegen einer festen Spannung an deren Gates wird also eine höhere Schaltgeschwindigkeit und damit eine höhere Folgefrequenz der Taktsignale ø1 und ø2 dadurch ermöglicht, dass eine leitende Reihenschaltung so lange nur den Schaltungspunkt D und nicht die übrigen, gesperrten Reihenschaltungen entlädt, bis der Inverter T4/T5 seinen endgültigen Schaltzustand erreicht hat.

Eine zweite Möglichkeit für die Spannung $V_G$ an den Gates der Transistoren TA, TB und TC besteht darin, diese mit dem Schaltungspunkt D zu verbinden, wie dies in Fig. 1 gestrichelt angedeutet ist. In diesem Falle werden die Reihenschaltungen während des Taktsignals ø2 auf eine Spannung aufgeladen, die um die Schwellwertspannung der Transistoren TA, TB und TC unterhalb der Spannung des Schaltungspunktes D liegt. Wenn dann dieser Schaltungspunkt D durch eine leitende Reihenschaltung, z.B. A, entladen wird, wird nur der Transistor TA leitend, während die Transistoren TB und TC bis zu einer maximalen Entladung, bei der die Spannung des Schaltungspunktes D und die Schwellwertspannung des Transistors TA über der Spannung $V_{SS}$ liegt, immer sperren. Die Transistoren TB und TC von gesperrten Reihenschaltungen verhalten sich dadurch also wie Dioden, die nur eine Aufladung bzw. Nachladung abgeflossener Ladung vom Schaltungspunkt D über den Transistor T1 erlauben, jedoch keine Entladung von gesperrten Reihenschaltungen über den Schaltungspunkt D.

Durch die Verbindung der Gates der Transistoren TA, TB und TC mit dem Schaltungspunkt D wächst jedoch die kapazitive Belastung des letzteren etwas, so dass dadurch dessen Umladung etwas verzögert wird, jedoch sehr viel weniger als bei fehlenden Transistoren TA, TB und TC.

Eine dritte Möglichkeit berücksichtigt, dass bei hohen Taktfrequenzen, also einer kurzen Aufladephase, (ø2 = High) in den Reihenschaltungen unterhalb der zusätzlichen Transistoren nicht alle Kapazitäten auf den vollen Wert $V_G - V_{TH}$ aufgeladen werden, sondern nur die den zusätzlichen Transistoren benachbarten Kapazitäten, da die Ladungen eine gewisse Zeit benötigen, bis sie am Drain des ersten gesperrten Transistors angekommen sind. Wenn z.B. in der Reihenschaltung B der Transistor TB1 sperrt, so ist am Ende einer kurzen Aufladephase ø2 seine Drain keineswegs auf $V_G - V_{TH}$ aufgeladen, sondern nur die Drain des Transistors TB3. Nachdem die Aufladephase beendet ist, tritt dann in der Reihenschaltung B eine gleichmässige Verteilung der Ladung ein, d.h. alle Kapazitäten dieser Reihenschaltung zwischen der Source des zusätzlichen Transistors TB und der Drain des Transistors TB1 stellen sich ungefähr auf die gleiche Spannung ein. Dazu muss aber Ladung vom Drainanschluss des Transistors TB3 abfliessen, d.h. dessen Spannung sinkt unter $V_G - V_{TH}$ ab, so dass der Transistor TB3 leitend werden kann und dann Ladungen vom Schaltungspunkt D abzieht. Passiert dies bei vielen parallelen Reihenschaltungen, so kann u.U. so viel Ladung vom Schaltungspunkt D abgezogen werden, dass die Schaltschwelle des nachfolgenden Inverters T4/T5 unterschritten wird, dieser also ein hohes Signal am Schaltungspunkt E abgibt, obwohl die Ladungen vom Schaltungspunkt D nicht über eine durchgeschaltete Reihenschaltung zum Bezugspotential $V_{SS}$ abgeflossen sind, sondern nur ein Ladungsausgleich innerhalb der einzelnen Reihenschaltungen stattfand.

Eine Massnahme, diesen Effekt, der bei sehr hohen Taktfrequenzen auftreten kann, durch geeignete Mittel zu beseitigen, besteht darin, die Spannung $V_G$ nicht konstant zu lassen, sondern während der Taktsignale ø2 zu erhöhen. Dies ist unten in Fig. 2 angedeutet, wobei die Spannung $V_G$ während des Taktsignals ø2 bis auf die positive Betriebsspannung $V_{DD}$ angehoben wird, während sie in der übrigen Zeit gleich der halben Betriebsspannung ist. Dadurch wird erreicht, dass während der Taktphase ø2 zumindest die dem Schaltungspunkt D zugewandten Enden aller Reihenschaltungen praktisch bis auf die Spannung am Schaltungspunkt D aufgeladen werden, d.h. entsprechend dem beschriebenen Zahlenbeispiel auf 4V. Wenn dann während des folgenden Taktsignals ø1 keine der Reihenschaltungen leitend ist, sind alle Transistoren TA, TB und TC mit Sicherheit gesperrt, da in der Abfragephase deren Gatespannung $V_G$ nur 2,5 V beträgt. Die auf dem dem Schaltungspunkt D zugewandten Ende der Reihenschaltung gespeicherten Ladungen können sich über die ganze Reihenschaltung bis zum ersten gesperrten Transistor gleichmässig verteilen. Die Reihenschaltung B würde erst dann Ladungen vom Schaltungspunkt D abziehen, wenn der Source-Anschluss des Transistors TB 3 bis auf die Spannung $V_G - V_{th} = 2,5\,V - 1V = 1,5\,V$ abgesunken wäre (infolge Ladungsausgleichs innerhalb der Reihenschaltung). Die Taktung von $V_G$ erhöht also die Zuverlässigkeit bzw. erlaubt höhere Taktfrequenzen.

Wesentlich bei allen Möglichkeiten ist also, dass die Transistoren TA, TB und TC ein solches Signal $V_G$ am Gate erhalten, dass diese Transistoren bei nichtleitenden Reihenschaltungen gesperrt sind, bis das Ausgangssignal seinen endgültigen Wert erreicht hat.

## Patentansprüche

1. Verknüpfungsschaltung in 2-Phasen-MOS-Technik mit mehreren gleichen Verknüpfungsgliedern, die je aus einer Reihenschaltung von die zu verknüpfenden Eingangssignale empfangenden MOS-Transistoren (TA1, TA2, TA3, TB1...) sowie eines ein Abfrage-Taktsignal (ø1) empfangenden Abfrage-MOS-Transistors (TA0, TB0, TC0...) bestehen, wobei das eine Ende jeder Reihenschaltung mit einem Bezugspotential und das andere Ende jeder Reihenschaltung über einen gemeinsamen Auflade-MOS-Transistor (T1), der das Auflade-Taktsignal (ø2) empfängt mit einer Betriebsspannung ($V_{DD}$) verbunden ist, wobei die Abfrage-Transistoren und der Auflade-Transistor niemals gleichzeitig leitend sind und die von der Betriebsspannung abgewandte und mit den Reihenschaltungen verbundene Hauptelektrode des Auflade-Transistors den Ausgang (D) der Verknüpfungsschaltung darstellt, an den das Gate mindestens eines Ausgangs-MOS-Transistors (T2) angeschlossen ist, der bei einer Spannung am Ausgang der Verknüpfungsschaltung zwischen der Betriebsspannung und einem Bruchteil davon ein eindeutig niedriges Signal abgibt, dadurch gekennzeichnet, dass in der Verbindung jeder Reihenschaltung mit dem Auflade-MOS-Transistor (T1) ein zusätzlicher MOS-Transistor (TA, TB, TC...) angeordnet ist und alle zusätzlichen MOS-Transistoren gemeinsam ein derartiges Signal ($V_G$) am Gate erhalten, dass zumindest während der leitenden Phase (ø1) der Abfrage-Transistoren (TA0, TB0, TC0...) zumindest bei Spannungen am Ausgang (D) der Verknüpfungsschaltung zwischen der Betriebsspannung ($V_{DD}$) und einem unterhalb des Bruchteils ($V_T$) davon liegenden Wert jeder zusätzliche MOS-Transistor (TA, TB, TC...) zwischen dem Auflade-MOS-Transistor (T1) und einer Reihenschaltung, die mindestens einen gesperrten Transistor (TA1, TA2, TA3, TB1...) enthält, gesperrt ist.

2. Verknüpfungsschaltung nach Anspruch 1, dadurch gekennzeichnet, dass die zusätzlichen MOS-Transistoren (TA, TB, TC...) Anreicherungs-MOS-Transistoren sind.

3. Verknüpfungsschaltung nach Anspruch 2, dadurch gekennzeichnet, dass das Signal ($V_G$) an den Gates der zusätzlichen MOS-Transistoren (TA, TB, TC...) eine Gleichspannung ist mit einem Wert kleiner als die Summe der niedrigsten Spannung, bei der der an dem Ausgang (D) der Verknüpfungsschaltung angeschlossene Ausgangs-MOS-Transistor (T5) noch ein eindeutig niedriges Signal abgibt, und der Schwellenspannung ($V_{TH}$) der zusätzlichen MOS-Transistoren (TA, TB, TC...).

4. Verknüpfungsschaltung nach Anspruch 2, dadurch gekennzeichnet, dass das Signal ($V_G$) an den Gates der zusätzlichen MOS-Transistoren (TA, TB, TC...) die Spannung am Ausgang (D) der Verknüpfungsschaltung ist.

5. Verknüpfungsschaltung nach Anspruch 2, dadurch gekennzeichnet, dass das Signal ($V_G$) an den Gates der zusätzlichen MOS-Transistoren (TA, TB, TC) ein Taktsignal ist, dessen Spannungswert bei leitenden Abfrage-MOS-Transistoren (TA0, TB0, TC0...) kleiner ist als die Summe der niedrigsten Spannung, bei der der an den Ausgang (D) der Verknüpfungsschaltung angeschlossene Ausgangs-MOS-Transistor (T5) noch ein eindeutig niedriges Signal abgibt, und der Schwellenspannung ($V_{TH}$) der zusätzlichen MOS-Transistoren (TA, TB, TC...), und dessen Spannungswert mindestens bei leitendem Auflade-MOS-Transistor (T1) grösser ist.

6. Verknüpfungsschaltung nach Anspruch 5, dadurch gekennzeichnet, dass der Spannungswert des Taktsignals bei leitendem Auflade-MOS-Transistor (T1) gleich der Betriebsspannung ($V_{DD}$) ist.

## Claims

1. A logic circuit using a 2-phase MOS technique, which circuit comprises a plurality of identical logic elements, which each comprise a series arrangement of MOS transistors (TA1, TA2, TA3, TB1,...) which receive the input signals to be processed, and a MOS sensing transistor TA0, TB0, TC0,...) which receives a sense clock signal (ø1), one end of each series arrangement being connected to a reference potential and the other end of each series arrangement being connected to an operating voltage ($V_{DD}$) via a common MOS charging transistor (T1) which receives the charge clock signal (ø2), the sensing transistors and the charging transistor never being conductive at the same time, the main electrode of the charging transistor which is not coupled to the operating voltage and which is connected to the series arrangements constituting the output (D) of the logic circuit, to which output the gate of at least one MOS output transistor (T5) is coupled which supplies an unambiguous low signal when the output of the logic circuit carries a voltage between the operating voltage and a fraction thereof, characterized in that in the connection of each series arrangement to the MOS charging transistor (T1) an additional MOS transistor (TA, TB, TC,...) is arranged and the gates of all additional MOS transistors together receive such a signal ($G_V$) that at least during the conductive phase (ø1) of the sensing transistors (TA0, TB0, TC0,...) each additional MOS transistor (TA, TB, TC,...) between the MOS charging transistor (T1) and a series arrangement with at least one cut-off transistor (TA1, TA2, TA3, TB1,...) is cut off at least for voltages between the operating voltage ($V_{DD}$) and a value lower than said fraction ($V_T$) on the logic circuit output (D).

2. A logic circuit as claimed in Claim 1, characterized in that the additional MOS transistors (TA, TB, TC,...) are enhancement-type MOS transistors.

3. A logic circuit as claimed in Claim 2, characterized in that the signal ($V_G$) on the gates of the additional MOS transistors (TA, TB, TC,...) is a direct voltage having a value smaller than the sum of the lowest voltage at which the output MOS transistor (T5) connected to the output (D) of the logic circuit still supplies an unambiguous low signal, and the threshold voltage ($V_{TH}$) of the additional MOS transistors (TA, TB, TC,...).

4. A logic circuit as claimed in Claim 2, characterized in that the signal ($V_G$) on the gates of the additional MOS transistors (TA, TB, TC,...) is the voltage on the output (D) of the logic circuit.

5. A logic circuit as claimed in Claim 2, characterized in that the signal ($V_G$) on the gates of the additional MOS transistors (TA, TB, TC) is a clock signal, whose voltage value when the MOS sensing transistors (TA0, TB0, TC0) conduct is smaller than the sum of the lowest voltage for which the output MOS transistor (T5) connected to the output (D) of the logic circuit still supplies an unambiguous low signal, and the threshold voltage ($V_{TH}$) of the additional MOS transistors (TA, TB, TC,...), and whose voltage value is greater at least when the MOS charging transistor (T1) conducts.

6. A logic circuit as claimed in Claim 5, characterized in that when the MOS charging transistor (T1) conducts, the voltage value of the clock signal is equal to the operating voltage ($V_{DD}$).

## Revendications

1. Circuit logique à technique MOS à 2 phases comportant plusieurs éléments logiques semblables qui sont formés chacun d'un montage en série des transistors MOS (TA1, TA2, TA3, TB1...) recevant les signaux d'entrée à combiner ainsi qu'un transistor MOS d'interrogation (TA0, TB0, TC0...) recevant un signal d'horloge d'interrogation (ø1), la première extrémité de chaque montage en série étant connectée à un potentiel de référence et l'autre extrémité de chaque montage en série étant connectée à une tension de service ($V_{DD}$) par l'intermédiaire d'un transistor de charge MOS (T1) commun qui reçoit le signal d'horloge de charge (ø2), les transistors d'interrogation et le transistor de charge n'étant jamais conducteurs simultanément et l'électrode principale du transistor de charge opposée à la tension de service et connectée au montage en série représentant la sortie (D) du circuit logique, à laquelle est connectée la porte d'au moins un transistor MOS de sortie (T2) qui, dans le cas de la présence sur la sortie du circuit logique d'une tension comprise entre la tension de service et une fraction de celle-ci, produit un signal bas non équivoque, caractérisé en ce que dans la jonction de chaque montage en série au transistor MOS de charge (T1) est prévu un transistor MOS supplémentaire (TA, TB, TC...), tous les transistors MOS supplémentaires recevant en commun sur les portes un signal (VG) tel qu'au moins pendant la phase de conduction (ø1) des transistors d'interrogation (TA0, TB0, TC0...), au moins pour des tensions à la sortie (D) du circuit logique comprises entre la tension de service ($V_{DD}$) et une valeur située en dessous de la fraction de cette tension ($V_T$), chaque transistor MOS supplémentaire (TA, TB, TC...) situé entre le transistor MOS de charge (T1) et un montage en série qui comporte au moins un transistor (TA1, TA2, TA3, TB1...) bloqué, est bloqué.

2. Circuit logique suivant la revendication 1, caractérisé en ce que les transistors MOS supplémentaires (TA, TB, TC...) sont des transistors MOS à enrichissement.

3. Circuit logique suivant la revendication 2, caractérisé en ce que le signal ($V_G$) à la porte des transistors MOS supplémentaires (TA, TB, TC...)

est une tension continue dont la valeur est inférieure à la somme de la tension la plus basse pour laquelle le transistor MOS de sortie (T5) connecté à la sortie (D) du circuit logique fournit encore un signal bas non équivoque et de la tension de seuil ($V_{TH}$) des transistors MOS supplémentaires (TA, TB, TC...).

4. Circuit logique suivant la revendication 2, caractérisé en ce que le signal ($V_G$) à la porte des transistors MOS supplémentaires (TA, TB, TC...) est la tension à la sortie (D) du circuit logique.

5. Circuit logique suivant la revendication 2, caractérisé en ce que le signal ($V_G$) à la porte des transistors MOS supplémentaires (TA, TB, TC) est un signal d'horloge dont la valeur de tension pour des transistors MOS d'interrogation (TA0, TB0, TC0...) est inférieure à la somme de la tension la plus basse pour laquelle le transistor MOS de sortie (T5) connecté à la sortie (D) du circuit logique fournit encore un signal bas non équivoque et de la tension de seuil ($V_{TH}$) des transistors MOS supplémentaires (TA, TB, TC...) et dont la valeur de tension est plus élevée au moins pour un transistor MOS de charge (T1) conducteur.

6. Circuit logique suivant la revendication 5, caractérisé en ce que la valeur de tension du signal d'horloge pour un transistor MOS de charge (T1) conducteur est égale à la tension de service ($V_{DD}$).

FIG.1

FIG.2